# EUROPEAN PATENT SPECIFICATION

(11) **EP 4 048 473 B1**
(45) Date of publication and mention of the grant of the patent: **25.03.2026**
(21) Application number: 20801151.0
(22) Date of filing: 20.10.2020
(51) Int. Cl.: H05K 1/02, H05K 3/34

(54) **SOLDER FOR ELECTRONICS ASSEMBLY AND METHOD OF FORMING A SOLDER JOINT**
LOT FÜR DIE ELEKTRONIKMONTAGE UND VERFAHREN ZUR HERSTELLUNG EINER LOTVERBINDUNG
SOUDER POUR ENSEMBLE ÉLECTRONIQUE ET PROCEDE DE FABRIQUE D'UN JOINT DE SOUDER

(30) Priority: 23.10.2019 US 201962924741 P
(43) Date of publication of application: 31.08.2022
(73) Proprietor: Alpha Assembly Solutions Inc., Waterbury, CT 06702 (US)
(72) Inventor: PANDHER, Ranjit, Waterbury, CT 06702 (US); NAGARAJAN, Niveditha, Waterbury, CT 06702 (US); SIDONE, Girard, Waterbury, CT 06702 (US); BILGRIEN, Carl, Waterbury, CT 06702 (US)
(74) Representative: Novagraaf Group
(86) International application number: PCT/EP2020/025466
(87) International publication number: WO 2021/078410

(56) References cited:
- WO-A1-2011/112722
- WO-A1-2019/231749
- US-B2- 10 123 430
- US-B2- 8 550 327

## Description

The invention relates to a solder material for use in electronic assembly.

There are two major challenges associates with the packaging and assembly of high-power electronic devices, such as IGBTs, MOSFETs, High-power LEDs, high power microprocessors and other large area devices generating a lot of heat during normal operation. The first is how to ensure efficient dissipation of the heat generated to maintain normal operating temperature. The second is how to reduce the shear stress due to coefficient of thermal expansion (CTE) mismatch between materials of the adjacent layers attached by a solder or other adhesive material.

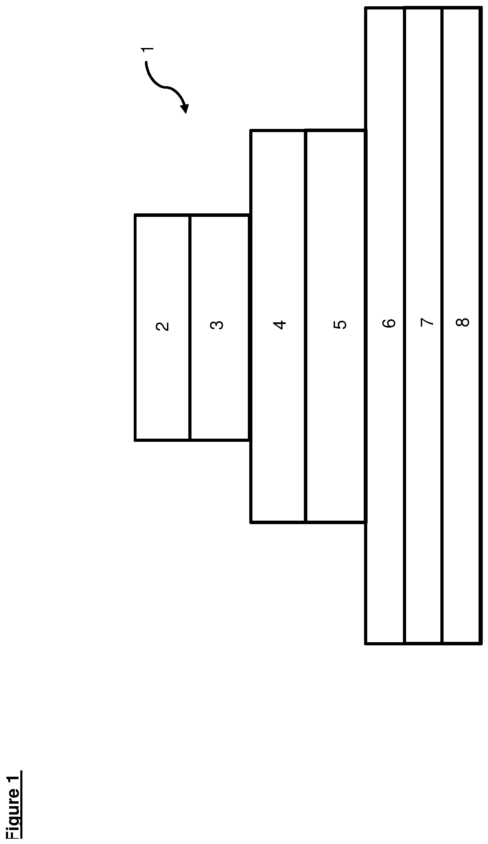

Figure 1 shows the assembly of a typical electronic device 1, which includes a device 2 connected via an interconnect 3 (Level I) to a substrate 4. The substrate 4 is connected via an interconnect 5 (Level II) to a printed circuit board (PCB) 6. The PCB 6 is connected via an interconnect 7 (Level III) to a heat sink 8. The most important interconnects for a high-power electronic device are those connecting device/die to substrate, substrate to printed circuit board (PCB) and PCB to heatsink, i.e. 3, 5 and 7 of Figure 1. Such interconnects are in the path of heat dissipation. Accordingly, high thermal conductivity of the interconnect material is desired. Semiconductor die, substrate and PCB materials have different CTEs, thereby resulting in a stress at the interface during high temperature operation. To minimize that stress, designers usually increase the interface thickness of the interconnect, but this in turn increases the thermal resistance of the interface.

Solders are one the most common interconnect materials used in electronic industry. Thermal conductivity of most of the solders is below 65 W/m.K. It would be advantageous to be able to use an interconnect material with higher thermal conductivity so as to aid heat dissipation. Another problem with thick solder interconnects is that during the reflow process, when solder is in the liquid phase, the die or substrate is floating on a liquid material before it is cooled down to below the solder's freezing temperature. This results in movement of the die/substrate in all directions (so-called "tilt"), which is another concern for the device performance and reliability. Controlling this die movement is a challenge. WO 2011/112722A1 discloses a core with a solder layer structure as the solder material.

The present invention seeks to tackle at least some of the problems associated with the prior art or at least to provide a commercially acceptable alternative solution thereto.

In a first aspect, as given in claim 1, the present invention provides a solder material for use in electronic assembly, the solder material comprising:
solder layers; and
a core layer comprising a core material, the core layer being sandwiched between the solder layers,
wherein:
the thermal conductivity of the core material is greater than the thermal conductivity of the solder.

Each aspect or embodiment as defined herein may be combined with any other aspect(s) or embodiment(s) unless clearly indicated to the contrary. In particular, any features indicated as being preferred or advantageous may be combined with any other feature indicated as being preferred or advantageous.

The inventors have surprisingly found that when used to connect components of an electronic device operated at elevated temperatures, such a solder material may be capable of reducing stress caused by a mismatch in CTE values of the connected components. Without being bound by theory, it is considered that the presence of the core material serves to "thicken" the joint between the connected components, thereby decreasing the stress. Advantageously, such a reduction in stress may be provided without significantly reducing heat dissipation from the connected parts. Without being bound by theory, it is considered that this is because the thermal conductivity of the core material is greater than the thermal conductivity of the solder. In other words, by using a core material having a greater thermal conductivity than that of the solder, it is possible to thicken the joint to reduce thermal stress without reducing heat dissipation. As a result, a high-power electronic device, such as an IGBT, MOSFET, high-power LEDs, high-power microprocessor or other large area device generating a lot of heat during normal operation, in which components are connected using the solder material, may exhibit improved performance and/or reliability. Such performance and reliability may be improved at elevated temperatures and/or during switching on and off.

A joint or interconnect formed using the solder material may better thermomechanical reliability as compared to typical Pb-free solders, such as SnCu, SAC, SnAg and SnBi.

The term "electronic assembly" used herein encompasses, for example, the assembly of electronic packages and devices and may include, for example, the attachment of a device or die to a substrate, a substrate to a printed circuit board, or a printed circuit board to a heat sink.

The term "solder" used herein encompasses a fusible metal or metal alloy with a melting point in the range of from 90 to 400 °C.

The solder material comprises solder layers and a core layer. The solder material may consist essentially of, or consist of, the solder layers and core layer. By "consisting essentially of", it is meant that the solder material may comprise other non-specified components provided that they do not materially affect the properties of the solder material.

The solder material typically comprises two solder layers, but may comprise more than two solder layers. The solder layers may be formed of the same solder or different solders. Typically, the solder layers are formed of the same solder, or at least solders having similar reflow temperatures, i.e. liquidus temperatures differing by no more than 20 °C, typically no more than 10 °C, more typically no more than 5 °C.

The solder and core are in the form of layers. Such layers will typically be in the form of a sheet, with two opposing surfaces (major surfaces) having a significantly greater surface area than the other surfaces. The solder layers may be the same size and shape or may be different sizes and/or shapes. The core layer may have a similar size and shape to one or more of the solder layers, or may have a different size and/or shape.

The core layer comprises a core material. The core layer may consist essentially of, or consist of, the core material.

The core layer is sandwiched between the solder layers. Typically, the solder layers will cover substantially the entirety of at least two opposing surfaces of the core layer, typically the major (i.e. greatest surface area) surfaces. The core layer may be entirely encapsulated within the solder so that no core material is exposed. In such a situation, a first solder sheet is considered to cover a major surface of the sheet, and a second solder layer is considered to cover the opposing major surface of the sheet, with the two solder layers "over hanging" the major surfaces so as to cover the remaining surfaces of the core layer. Alternatively, the core layer may be covered by solder layers on only some of the surfaces, typically only two opposing surfaces, more typically the major surfaces.

The solder layers are typically in direct contact with the core layer. The solders layers are typically outer layers.

The thermal conductivity of the core material is greater than the thermal conductivity of the solder. Typically, such thermal conductivity is measured by a nano-flash transient measurement technique.

The core material preferably has a thermal conductivity of greater than or equal to 65 W/m.K, preferably greater than 65 w/m.K, more preferably greater than 70 W/m.k, even more preferably greater than 75 W/m.K. Such thermal conductivity may be measured by a nano-flash transient measurement technique. Since typical solders employed in electronic assembly have a thermal conductivity of less than 65 w/m.K, the presence of the core material having a higher thermal conductivity increases the overall thermal conductivity of the solder material.

The melting point of the core material is preferably greater than the reflow temperature of the solder. For example, the core material may have a melting temperature that is at least 50 °C higher than the reflow temperature of the solder, typically at least 75 °C higher, more typically at least 100 °C higher. The term "reflow temperature" is used herein to refer to the temperature above which a solid mass of solder is certain to melt (as opposed to merely soften). If cooled below this temperature, the solder will not flow. Warmed above it once more, the solder will flow again, i.e. "re-flow". By having a core material with a melting temperature higher than the reflow temperature of the solder, the thickness of the joint / interconnect may be increased without a substantial increase in the die/package movement and/or tilt, which results from the die/package floating on top of the liquid solder when the solder is in the liquid state. This may improve the performance or reliability of an electronic device having components connected using the solder material.

The thickness of the core layer is from 150 to 300 µm. Such thicknesses may be particularly suitable for reducing stress caused by CTE mismatch of components without unduly increasing the size of the electronic device. Larger thicknesses may increase the thermal resistance. Relatively higher thickness may result in higher resistance but lower lateral stress.

The thickness of each solder layer is from 50 to 100 µm. Such thicknesses may be particularly suitable for providing adequate adhesion between components without significantly decreasing the overall thermal conductivity of the solder material or unduly increasing the size of the device. Lower thicknesses may result in higher lateral stress during high temperature operation of temperature cycling.

Thickness of the core and the solder layers may be selected as desired by the package design and to achieve the desired thickness of the interconnect. Metal and metal alloy may provide sufficient electrical conductivity to provide a high level electrical connection between components joined by the soldering material.

The core material comprises one or more of copper and silver. Such materials may provide a favourable combination of high electrical conductivity and high thermal conductivity. The CTE of the core material will have an impact on the stress at the interfaces. This stress can be reduced by selecting an appropriate core material. For example, CTE of Nickel is 13 ppm/K while that of Copper in 17 ppm/K and CTE of CuW alloy depends on the composition and can be tailored to meet the device design needs.

The core material preferably has an electrical conductivity at 20 °C of at least 1 x 10⁵ S/m, more preferably at least 1 x 10⁶ S/m, more preferably at least 1 x 10⁷ S/m, even more preferably at least 4 x 10⁷ S/m, still even more preferably at least 5 x 10⁷ S/m. Such electrical conductivities may provide a high level of electrical connection between components joined by the soldering material.

The solder is preferably lead-free. This means that no lead is added intentionally. Thus, the lead content is zero or at no more than accidental impurity levels. Lead-free solder may be favourable in view of health concerns and regulatory requirements.

The solder preferably comprises one or more of: In, SnIn alloy (e.g. 5-58% Sn, 42-95% In), SnBi alloy (e.g. 42-60% Sn, 40-58% Bi), Biln alloy (e.g. 5-67% Bi, 33-95% In), Agln alloy (e.g.1-5%Ag, 95-99% In, e.g. 3% Ag, 97% In), SnAg alloy (e.g. 90-97.5% Sn, 2.5-10% Ag), SnCu alloy (e.g. 99.3-99.6% Sn, 0.4-0.7% Cu), InGa alloy (e.g. 99.3-99.5% In, 0.5-0.7% Ga), SnBiAgCu alloy (e.g. 50% Sn, 47% Bi, 1% Ag, 2% Cu), SnBiZn alloy (e.g. 65.5% Sn, 31.5% Bi, 3% Zn), SnInAg alloy (e.g. 77.2% Sn, 20% In, 2.8% Ag), SnBiAgCuln alloy (e.g. 82.3% Sn, 2.2% Bi, 3% Ag, 0.5% Cu, 12% In), SnZn alloy (e.g. 91% Sn, 9% Zn), SnCulnGa alloy (e.g. 92.8% Sn, 0.7%Cu, 6% In, 0.5% Ga), SnCuAg alloy (e.g. 95.5% Sn, 3.8% Ag, 0.7% Cu), SnAgSb alloy (e.g. 95% Sn, 3.5% Ag, 1.5% Sb) and SnCuSb alloy (e.g. 4-95% Sn, 1-2% Cu, 4% Sb). % values refer to % by weight. The alloys may comprise the recited elements together with any unavoidable impurities. Such alloys may be particularly suitable for connecting components of an electrical device.

In a preferred example, the core material comprises copper and the solder comprises Sn-20In-2Ag alloy.

The solder material is preferably in the form of a foil, a strip, a film, a ribbon or a preform. Such forms may be particularly suitable for connecting components of an electronic device and/or may exhibit favourable handling properties.

In a preferred embodiment, the core is completely coated with the solder. In other words, the core is completely surrounded by solder and no portion of the core is exposed. In this case, no part of the core material is exposed to air or other operating environments. This design may be preferred for core materials that tend get oxidized when exposed to oxygen and/or humidity such as, for example, Cu or Ni.

In an alternative preferred embodiment, the core is coated with solder on only two opposing surfaces, typically the two largest opposing surfaces (major surfaces). This design may be relatively easy for high volume manufacturing as large size sheets or ribbons can be coated with the solder from which preform can cut by a high-speed stamping process.

The solder material preferably has an effective thermal conductivity of greater than 65 W/m.K, more preferably greater than 80 W/m.K, even more preferably greater than 100 W/m.K, still even more preferably greater than 130 W/m.K. By "effective thermal conductivity" it is meant the total thermal conductivity of the solder material, i.e. including both the solder (with lower thermal conductivity) and the core (with higher thermal conductivity). Such an effective thermal conductivity may improve the heat dissipation from the solder material.

The first aspect of the present invention relates to a solder material. The term "solder material" may be synonymous with the term "multilayered structure". In addition, the term "solder layers" is synonymous with the term "two or more solder layers". In addition, for the avoidance of doubt, the solder layers comprise solder material. The solder layers are typically outer layers.

Accordingly, the first aspect of the present invention which is given in claim 1 is alternatively worded as a multilayered material for use in electronic assembly, the multilayered material comprising:
two or more (e.g. outer) solder layers, each solder later comprising solder material; and
a core layer comprising a core material, the core layer being sandwiched between the two or more solder layers,
wherein:
the thermal conductivity of the core material is greater than the thermal conductivity of the solder material.

In a further aspect, the present invention provides a solder joint, given in claim 6, comprising the solder material described herein. For the avoidance of doubt, the advantages and preferable features of the first aspect apply equally to this aspect. Such a joint may exhibit a favourable combination of low stress caused by CTE mismatch of the joined components and high heat dissipation. Accordingly, an electronic device containing such a joint may exhibit improved performance and reliability in comparison to conventional electronic devices. The thickness of the solder joint corresponds to the sum of the thickness of the core layer and the solder layers. Typically, the thickness does not change during reflow.

In a further aspect, the present invention provides an interconnect, given in claim 7, comprising the solder material described herein. For the avoidance of doubt, the advantages and preferable features of the first aspect apply equally to this aspect. Such an interconnection may exhibit a favourable combination of low stress caused by CTE mismatch of the joined components and high heat dissipation. Accordingly, an electronic device containing such an interconnection may exhibit improved performance and reliability in comparison to conventional electronic devices.

In a further aspect, the present invention, as given in claim 8, provides an IGBT, MOSFET, LED or microprocessor comprising the solder material, the solder joint or the interconnect described herein. For the avoidance of doubt, the advantages and preferable features of the first aspect apply equally to this aspect. Such a device may exhibit improved performance and reliability in comparison to conventional electronic devices.

In a further aspect, the present invention, as given in claim 9, provides the use of the solder material described herein in a soldering method selected from Surface Mount Technology (SMT) soldering, die attach soldering, thermal interface soldering, hand soldering, laser and RF induction soldering, and thermos-sonic soldering. For the avoidance of doubt, the advantages and preferable features of the first aspect apply equally to this aspect. The solder materials described herein are particularly suitable for such uses.

In a further aspect, the present invention provides the use of the solder material described herein for die-attach (Level I), substrate attach (Level II) or package to heatsink attach (Level III). For the avoidance of doubt, the advantages and preferable features of the first aspect apply equally to this aspect.

The solder materials described herein are particularly suitable for such uses.

In a further aspect, the present invention, as given in claim 10, provides a method of forming a solder joint comprising:
providing the solder material described herein in the vicinity of two or more work pieces to be joined, and
heating the solder material to form a soldered joint.

For the avoidance of doubt, the advantages and preferable features of the first aspect apply equally to this aspect. The resulting joint may exhibit a favourable combination of low stress caused by CTE mismatch of the joined components and high heat dissipation. Accordingly, an electronic device containing such a joint may exhibit improved performance and reliability in comparison to conventional electronic devices.

The two or more work pieces to be joined preferably comprise:
a device or die and a substrate, or
a substrate and a printed circuit board (PCB), or
a printed circuit board and a heatsink.

Such work pieces are particularly suitable to be joined by the solder material, since they are required to have a high heat dissipation and it is beneficial for them to exhibit low stress resulting from CTE mismatch.

In a further aspect, the present invention, a given in claim 11, provides a method of manufacturing the solder material described herein, the method comprising:
providing two of more layers of solder,
providing a layer of core material, and
laminating the layers of solder on either side of the layer of core material.

For the avoidance of doubt, the advantages and preferable features of the first aspect apply equally to this aspect. Depending on the solder and the core material, as well as the processing conditions, there is a reduction in the thickness of the structure after lamination. That reduction factor must be accounted for to achieve the target dimensions.

The layer of core material is preferably in the form of a ribbon and/or the layer of solder is in the form of a ribbon.

The ribbons are preferably provided by casting, extrusion or drawing.

The layers are preferably laminated in a co-drawing process, preferably a high-pressure co-drawing process.

The laminated layers are preferably diced and/or stamped.

In a further aspect, the present invention, as given in claim 13, provides a method of manufacturing the solder material described herein, the method comprising:
providing a layer of core material, and
coating the core material with solder.

The surface of the layer of core material is preferably cleaned prior to it being coated with the solder. This may result in a stronger adhesion between the core and solder, thereby reducing the occurrence of delamination and the resulting loss of reliability of a device containing a joint formed using the solder material.

Coating the core material with solder preferably comprises contacting the core material with a molten solder bath, e.g. by immersing the core material in a molten solder bath.

Various process parameters, such as the solder bath temperature, ribbon speed though the bath etc. may be a varied to control the solder coating thickness.

The invention will now be described in relation to the following non-limiting drawings in which:
Figure 1 shows a schematic of the assembly of a typical electronic device.
Figure 2 shows cross-sectional schematics of alternative arrangements of the solder material according to the present invention.
Figure 3 shows a microscopy image of a cross section of a solder material according to the present invention.

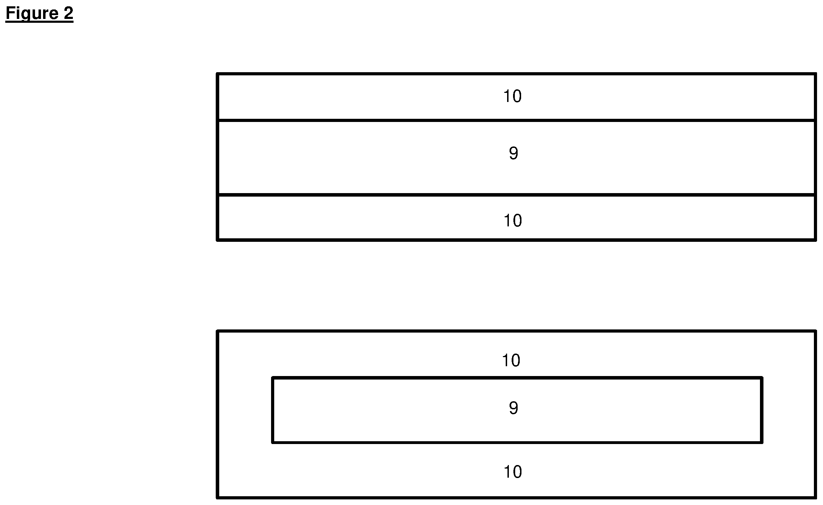

Figure 2 shows a cross-sectional view of two types of solder material according to the present invention. The solder materials comprise a core layer 9 sandwiched between solder layers 10. The solder material shown in the top picture has solder only at the top and at the bottom side. There is no solder on the sides. The other solder material has solder on all sides of the core.

The invention will now be described in relation to the following non-limiting examples.

### Example 1

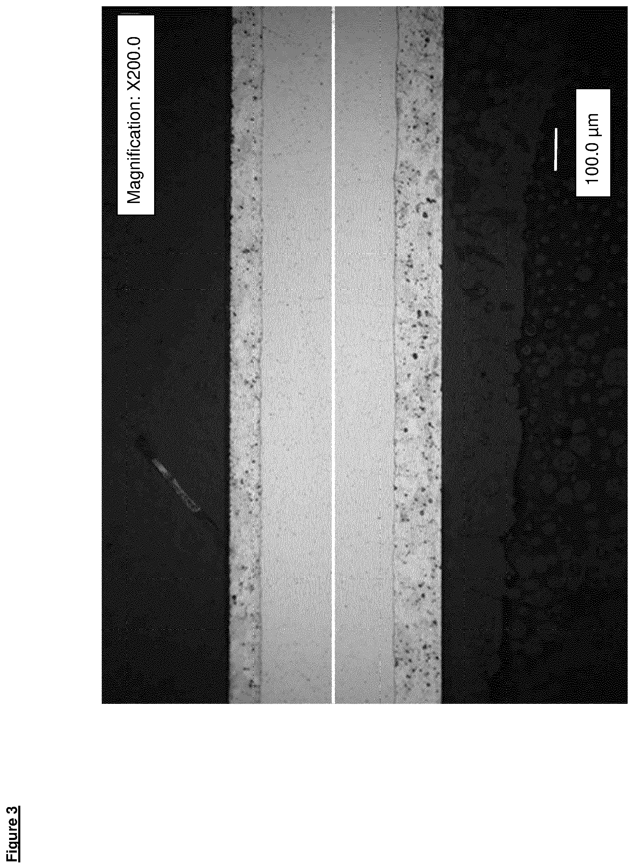

A solder material (preform) was prepared by a high-pressure lamination process. Figure 3 shows a microscopy image of a cross section of the preform. The central core is 300 µm thick and formed of copper. The solder on both sides is Sn20%ln2%Ag. The solder thickness varies from 50 to 100 µm. The effective thermal conductivity of this sample is about 130 W/m.K, measured by a nano-flash transient measurement technique.

### Example 2

A number of preforms were prepared in a similar manner to Example 1 but with varying thicknesses of the core (Keff = 400 W/m.K) and solder layers (Keff = 54 W/m.K). The thermal performance of the preforms was evaluated. Table 1 shows estimated thermal resistances and equivalent thermal conductivities. The thermal resistance of the hick interfaces is much lower (equivalent Keff is much higher) as compared to solder alone.

**Table 2: Selected examples of Cu-core preforms with their estimated thermal resistance and equivalent thermal conductivity.**

| Length (mm) | Width (mm) | Core thickness (mm) | Solder thickness on each side | Thermal Resistance (C/W) | Equivalent Keff (W/m.K) |
|---|---|---|---|---|---|
| 10 | 10 | 0.2 | 0.1 | 0.0420 | 95.2 |
| 10 | 10 | 0.2 | 0.05 | 0.0235 | 127.6 |
| 10 | 10 | 0.3 | 0.1 | 0.0445 | 112.3 |
| 10 | 10 | 0.3 | 0.05 | 0.0260 | 153.7 |
| 10 | 10 | 0.4 | 0.1 | 0.0470 | 127.6 |
| 10 | 10 | 0.4 | 0.05 | 0.0285 | 175.3 |

The foregoing detailed description has been provided by way of explanation and illustration, and is not intended to limit the scope of the appended claims. Many variations in the presently preferred embodiments illustrated herein will be apparent to one of ordinary skill in the art and remain within the scope of the appended claims.

## Claims

1. A solder material for use in electronic assembly, the solder material comprising:
solder layers; and
a core layer comprising a core material, the core layer being sandwiched between the solder layers,
wherein:
the thermal conductivity of the core material is greater than the thermal conductivity of the solder,
the thickness of the core layer is from 150 to 300 µm,
the thickness of each solder layer is from 50 to 100 µm, and
the core material comprises one or more of copper and silver.

2. The solder material of claim 1, wherein the core material has a thermal conductivity of greater than or equal to 65 W/m.K, preferably greater than 65 w/m.K, more preferably greater than 70 W/m.k, even more preferably greater than 75 W/m.K; and/or
wherein the melting point of the core material is greater than the reflow temperature of the solder.

3. The solder material of any preceding claim, wherein the solder is lead-free.

4. The solder material of any preceding claim, wherein the solder comprises one or more of: In, SnIn alloy (e.g. 5-58% Sn, 42-95% In), SnBi alloy (e.g. 42-60% Sn, 40-58% Bi), Biln alloy (e.g. 5-67% Bi, 33-95% In), Agln alloy (e.g. 3% Ag, 97% In), SnAg alloy (e.g. 90-97.5% Sn, 2.5-10% Ag), SnCu alloy (e.g. 99.3-99.6% Sn, 0.4-0.7% Cu), InGa alloy (e.g. 99.3-99.5% In, 0.5-0.7% Ga), SnBiAgCu alloy (e.g. 50% Sn, 47% Bi, 1% Ag, 2% Cu), SnBiZn alloy (e.g. 65.5% Sn, 31.5% Bi, 3% Zn), SnInAg alloy (e.g. 77.2% Sn, 20% In, 2.8% Ag), SnBiAgCuln alloy (e.g. 82.3% Sn, 2.2% Bi, 3% Ag, 0.5% Cu, 12% In), SnZn alloy (e.g. 91% Sn, 9% Zn), SnCuInGa alloy (e.g. 92.8% Sn, 0.7%Cu, 6% In, 0.5% Ga), SnCuAg alloy (e.g. 95.5% Sn, 3.8% Ag, 0.7% Cu), SnAgSb alloy (e.g. 95% Sn, 3.5% Ag, 1.5% Sb) and SnCuSb alloy (e.g. 4-95% Sn, 1-2% Cu, 4% Sb).

5. The solder material of any preceding claim, wherein the core material comprises copper and the solder comprises Sn-20In-2Ag alloy; and/or
wherein the solder material is in the form of a foil, a strip, a film, a ribbon or a preform; and/or
wherein the core is completely coated with the solder; and/or
wherein the solder material has an effective thermal conductivity of greater than 65 W/m.K, preferably greater than 80 W/m.K, more preferably greater than 100 W/m.K, even more preferably greater than 130 W/m.K.

6. A solder joint comprising the solder material of any preceding claim.

7. An interconnect comprising the solder material of any of claims 1 to 5.

8. An IGBT, MOSFET, LED or microprocessor comprising the solder material of any of claims 1 to 5, the solder joint of claim 6 or the interconnect of claim 7.

9. Use of the solder material of any of claims 1 to 5 in a soldering method selected from Surface Mount Technology (SMT) soldering, die attach soldering, thermal interface soldering, hand soldering, laser and RF induction soldering, and thermos-sonic soldering; or
for die-attach (Level I), substrate attach (Level II) or package to heatsink attach (Level III).

10. A method of forming a solder joint comprising:
providing the solder material of any of claims 1 to 5 in the vicinity of two or more work pieces to be joined, and
heating the solder material to form a soldered joint, preferably wherein the two or more work pieces to be joined comprise:
a device or die and a substrate, or
a substrate and a printed circuit board (PCB), or
a printed circuit board and a heatsink.

11. A method of manufacturing the solder material of any of claims 1 to 5, the method comprising:
providing two of more layers of solder,
providing a layer of core material, and
laminating the layers of solder on either side of the layer of core material.

12. The method of claim 11, wherein the layer of core material is in the form of a ribbon and/or the layer of solder is in the form of a ribbon, preferably wherein the ribbons are provided by casting, extrusion or drawing; and/or
wherein the layers are laminated in a co-drawing process, preferably a high-pressure co-drawing process; and/or
wherein the laminated layers are diced and/or stamped.

13. A method of manufacturing the solder material of any of claims 1 to 5, the method comprising:
providing a layer of core material, and
coating the core material with solder.

14. The method of claim 13, wherein the surface of the layer of core material is cleaned prior to it being coated with the solder; and/or
wherein coating the core material with solder comprises contacting the core material with a molten solder bath.

## Patentansprüche

1. Lötmaterial zur Verwendung in der Elektronikfertigung, das Lötmaterial umfassend:
Lötschichten; und
eine Kernschicht umfassend ein Kernmaterial, wobei die Kernschicht sandwichartig zwischen den Lötschichten angeordnet ist,
wobei:
die Wärmeleitfähigkeit des Kernmaterials größer ist als die Wärmeleitfähigkeit des Lötmittels,
die Dicke der Kernschicht 150 bis 300 µm beträgt,
die Dicke jeder Lötschicht 50 bis 100 µm beträgt, und
das Kernmaterial eines oder mehrere von Kupfer und Silber umfasst.

2. Lötmaterial nach Anspruch 1, wobei das Kernmaterial eine Wärmeleitfähigkeit von größer als oder gleich 65 W/m·K aufweist, vorzugsweise größer als 65 W/m·K, mehr bevorzugt größer als 70 W/m·K, noch mehr bevorzugt größer als 75 W/m·K; und/oder
wobei der Schmelzpunkt des Kernmaterials größer ist als die Aufschmelztemperatur des Lötmittels.

3. Lötmaterial nach einem der vorstehenden Ansprüche, wobei das Lötmittel bleifrei ist.

4. Lötmaterial nach einem der vorstehenden Ansprüche, wobei das Lötmittel eines oder mehrere der Folgenden umfasst: In, Snln-Legierung (z. B. 5-58 % Sn, 42-95 % In), SnBi-Legierung (z. B. 42-60 % Sn, 40-58 % Bi), Biln-Legierung (z. B. 5-67 % Bi, 33-95 % In), Agln-Legierung (z. B. 3 % Ag, 97 % In), SnAg-Legierung (z. B. 90-97,5 % Sn, 2,5-10 % Ag), SnCu-Legierung (z. B. 99,3-99,6 % Sn, 0,4-0,7 % Cu), InGa-Legierung (z. B. 99,3-99,5 % In, 0,5-0,7 % Ga), SnBiAgCu-Legierung (z. B. 50 % Sn, 47 % Bi, 1 % Ag, 2 % Cu), SnBiZn-Legierung (z. B. 65,5 % Sn, 31,5 % Bi, 3 % Zn), SnInAg-Legierung (z. B. 77,2 % Sn, 20 % In, 2,8 % Ag), SnBiAgCuln-Legierung (z. B. 82,3 % Sn, 2,2 % Bi, 3 % Ag, 0,5 % Cu, 12 % In), SnZn-Legierung (z. B. 91 % Sn, 9 % Zn), SnCulnGa-Legierung (z. B. 92,8 % Sn, 0,7 %Cu, 6 % In, 0,5 % Ga), SnCuAg-Legierung (z. B. 95,5 % Sn, 3,8 % Ag, 0,7 % Cu), SnAgSb-Legierung (z. B. 95 % Sn, 3,5 % Ag, 1,5 % Sb) und SnCuSb-Legierung (z. B. 4-95 % Sn, 1-2 % Cu, 4 % Sb).

5. Lötmaterial nach einem der vorstehenden Ansprüche, wobei das Kernmaterial Kupfer umfasst und das Lötmittel eine Sn-20In-2Ag-Legierung umfasst; und/oder
wobei das Lötmaterial in Form einer Folie, eines Streifens, eines Films, eines Bandes oder eines Vorformlings vorliegt; und/oder
wobei der Kern vollständig mit dem Lötmittel beschichtet ist; und/oder
wobei das Lötmaterial eine effektive Wärmeleitfähigkeit von größer als 65 W/m·K aufweist, vorzugsweise größer als 80 W/m·K, mehr bevorzugt größer als 100 W/m·K, noch mehr bevorzugt größer als 130 W/m·K.

6. Lötverbindung, umfassend das Lötmaterial nach einem der vorstehenden Ansprüche.

7. Verbindungsstelle, umfassend das Lötmaterial nach einem der Ansprüche 1 bis 5.

8. IGBT, MOSFET, LED oder Mikroprozessor, umfassend das Lötmaterial nach einem der Ansprüche 1 bis 5, die Lötverbindung nach Anspruch 6 oder die Verbindung nach Anspruch 7.

9. Verwendung eines Lötmaterial nach einem der Ansprüche 1 bis 5 in einem Lötverfahren, wobei das Lötverfahren vorzugsweise aus Surface Mount Technology-Löten (SMT-Löten), Die-Anschlusslöten, Löten thermischer Schnittstellen, Handlöten, Laser- und HF-Induktionslöten und Thermo-Sonic-Löten ausgewählt ist; oder
zur Die-Befestigung (Ebene I), Substratbefestigung (Ebene II) oder Gehäuse-zu-Kühlkörper-Befestigung (Ebene III).

10. Verfahren zum Ausbilden einer Lötverbindung, umfassend:
Bereitstellen des Lötmaterials nach einem der Ansprüche 1 bis 5 in der Nähe von zwei oder mehr zu fügenden Werkstücken, und
Erwärmen des Lötmaterials zum Ausbilden einer gelöteten Verbindung, vorzugsweise wobei die zwei oder mehr zu verbindenden Werkstücke umfassen:
eine Vorrichtung oder ein Die und ein Substrat, oder
ein Substrat und eine Leiterplatte (PCB) oder
eine Leiterplatte und ein Kühlkörper.

11. Verfahren zum Herstellen des Lötmaterials nach einem der Ansprüche 1 bis 5, das Verfahren umfassend:
Bereitstellen von zwei oder mehr Lötmittelschichten,
Bereitstellen einer Kernmaterialschicht, und
Laminieren der Lötmittelschichten auf beiden Seiten der Kernmaterialschicht.

12. Verfahren nach Anspruch 11, wobei die Kernmaterialschicht in Form eines Bandes vorliegt und/oder die Lötmittelschicht in Form eines Bandes vorliegt, vorzugsweise wobei die Bänder durch Gießen, Extrusion oder Ziehen bereitgestellt werden; und/oder
wobei die Schichten in einem Co-Zieh-Prozess laminiert werden, vorzugsweise einem Hochdruck-Co-Zieh-Prozess; und/oder
wobei die laminierten Schichten gewürfelt und/oder gestanzt werden.

13. Verfahren zum Herstellen des Lötmaterials nach einem der Ansprüche 1 bis 5, das Verfahren umfassend:
Bereitstellen einer Kernmaterialschicht, und
Beschichtung des Kernmaterials mit Lötmittel.

14. Verfahren nach Anspruch 13, wobei die Oberfläche der Kernmaterialschicht gereinigt wird, bevor sie mit dem Lötmittel beschichtet wird; und/oder
wobei das Beschichten des Kernmaterials mit Lötmittel das Kontaktieren des Kernmaterials mit einem Schmelzlötbad umfasst.

## Revendications

1. Matériau de soudure destiné à être utilisé dans un assemblage électronique, le matériau de soudure comprenant :
des couches de soudure ; et
une couche centrale comprenant un matériau central, la couche centrale étant prise en sandwich entre les couches de soudure,
dans lequel :
la conductivité thermique du matériau central est supérieure à la conductivité thermique de la soudure,
l'épaisseur de la couche de base est comprise entre 150 et 300 µm,
l'épaisseur de chaque couche de soudure va de 50 à 100 µm, et
le matériau central comprend un ou plusieurs parmi le cuivre et l'argent.

2. Matériau de soudure selon la revendication 1, dans lequel le matériau central a une conductivité thermique supérieure ou égale à 65 W/m.K, de préférence supérieure à 65 w/m.K, plus préférablement supérieure à 70 W/m.K, encore plus préférablement supérieure à 75 W/m.K ; et/ou
dans lequel le point de fusion du matériau central est supérieur à la température de refusion de la soudure.

3. Matériau de soudure selon l'une quelconque revendication précédente, dans lequel la soudure est sans plomb.

4. Matériau de soudure selon l'une quelconque revendication précédente, dans lequel la soudure comprend un ou plusieurs parmi : In, un alliage SnIn (par exemple 5 à 58 % Sn, 42 à 95 % In), un alliage SnBi (par exemple 42 à 60 % Sn, 40 à 58 % Bi), un alliage Biln (par exemple 5 à 67 % Bi, 33 à 95 % In), un alliage Agln (par exemple 3 % Ag, 97 % In), un alliage SnAg (par exemple 90 à 97,5 % Sn, 2,5 à 10 % Ag), un alliage SnCu (par exemple 99,3 à 99,6 % Sn, 0,4 à 0,7 % Cu), un alliage InGa (par exemple 99,3 à 99,5 % In, 0,5 à 0,7 % Ga), un alliage SnBiAgCu (par exemple 50 % Sn, 47 % Bi, 1 % Ag, 2 % Cu), un alliage SnBiZn (par exemple 65,5 % de Sn, 31,5 % Bi, 3 % Zn), un alliage SnInAg (par exemple 77,2 % de Sn, 20 % In, 2,8 % Ag), un alliage SnBiAgCuln (par exemple 82,3 % de Sn, 2,2 % Bi, 3 % Ag, 0,5 % Cu, 12 % In), un alliage SnZn (par exemple 91 % de Sn, 9 % de Zn), un alliage SnCulnGa (par exemple 92,8 % de Sn, 0,7 % Cu, 6 % In, 0,5 % Ga), un alliage de SnCuAg (par exemple 95,5 % de Sn, 3,8 % Ag, 0,7 % Cu), un alliage SnAgSb (par exemple 95 % de Sn, 3,5 % Ag, 1,5 % de Sb) et un alliage SnCuSb (par exemple 4 à 95 % de Sn, 1 à 2 % de Cu, 4 % de Sb).

5. Matériau de soudure selon l'une quelconque revendication précédente, dans lequel le matériau central comprend du cuivre et la soudure comprend un alliage Sn à 20In à 2Ag ; et/ou
dans lequel le matériau de soudure se présente sous la forme d'une feuille, d'une bande, d'un film, d'un ruban ou d'une préforme ; et/ou
dans lequel le cœur est complètement recouvert de la soudure ; et/ou
dans lequel le matériau de soudure a une conductivité thermique effective supérieure à 65 W/m.K, de préférence supérieure à 80 W/m.K, plus préférablement supérieure à 100 W/m.K, encore plus préférablement supérieure à 130 W/m.K.

6. Joint de soudure comprenant le matériau de soudure selon l'une quelconque revendication précédente.

7. Interconnexion comprenant le matériau de soudure selon l'une quelconque des revendications 1 à 5.

8. IGBT, MOSFET, DEL ou microprocesseur comprenant le matériau de soudure selon l'une quelconque des revendications 1 à 5, joint de soudure selon la revendication 6 ou interconnexion selon la revendication 7.

9. Utilisation du matériau de soudure selon l'une quelconque des revendications 1 à 5 dans un procédé de soudage sélectionné parmi la soudure par technologie de montage en surface (SMT), la soudure de fixation de puce, la soudure d'interface thermique, la soudure manuelle, la soudure laser et par induction RF, et la soudure thermos-sonic ; ou
pour la fixation de puce (niveau I), la fixation de substrat (niveau II) ou la fixation de boîtier au dissipateur thermique (niveau III).

10. Procédé de formation d'un joint de soudure comprenant :
la fourniture du matériau de soudure selon l'une quelconque des revendications 1 à 5 à proximité de deux pièces à usiner ou plus à assembler, et
le chauffage du matériau de soudure pour former un joint soudé, de préférence dans lequel les deux pièces à usiner ou plus à assembler comprennent :
un dispositif ou une puce et un substrat, ou
un substrat et une carte de circuit imprimé (PCB), ou
une carte de circuit imprimé et un dissipateur thermique.

11. Procédé de fabrication du matériau de soudure selon l'une quelconque des revendications 1 à 5, le procédé comprenant :
la fourniture de deux couches de soudure ou plus,
la fourniture d'une couche de matériau central, et
la stratification des couches de soudure de part et d'autre de la couche de matériau central.

12. Procédé selon la revendication 11, dans lequel la couche de matériau central est sous la forme d'un ruban et/ou la couche de soudure a la forme d'un ruban, de préférence dans lequel les rubans sont fournis par moulage, extrusion ou étirage ; et/ou
dans lequel les couches sont stratifiées dans un processus co-étirage, de préférence un processus de co-étirage à haute pression ; et/ou
dans lequel les couches stratifiées sont coupées en dés et/ou estampées.

13. Procédé de fabrication du matériau de brasure selon l'une quelconque des revendications 1 à 5, le procédé comprenant :
la fourniture d'une couche de matériau central, et
le revêtement du matériau central avec de la soudure.

14. Procédé selon la revendication 13, dans lequel la surface de la couche de matériau central est nettoyée avant d'être recouverte de la soudure ; et/ou
dans lequel le revêtement du matériau central avec de la soudure comprend la mise en contact du matériau central avec un bain de soudure fondu.
